# EUROPEAN PATENT APPLICATION

(11) **EP 0 785 327 A1**
(43) Date of publication of application: **23.07.1997**
(21) Application number: 97300336.1
(22) Date of filing: 20.01.1997
(51) Int. Cl.: E05B 65/00, H05K 9/00, F16B 21/02, B65D 43/22

(54) **Improvements relating to fasteners**

(30) Priority: 18.01.1996 GB 9600996
(71) Applicant: Ross Courtney Limited, Kingswinford, West Midlands DY6 7PP (GB); Salamandre Plc, Swindon, Wiltshire SN3 4RE (GB)
(72) Inventor: Wall, Jonathan Richard, Wolverhampton, West Midlands WV10 6JY (GB)
(74) Representative: Barnfather, Karl Jon, Dr.

(57) **Abstract**

A turn buckle fastener (Figure 6) has a head (20) to seat on one part and a shank (22) which is journalled in that part. A spring clip is received in a transverse bore and has one tail (24) projecting at one end of the bore and a longer tail (28) in the other end of the bore. The tail (24) frictionally abuts the underside of the part in which the shank (22) is journalled, so as to anchor it in position axially and provide a limited resistance to turning, and the tail (28) is to be engaged with another part when the fastener is appropriately turned, so as to secure the parts together.

## Description

This invention relates to fasteners and particularly ones of a well known kind where a member is to be turned through part of a single revolution between engaged and released positions, such a fastener is herein called a turnbuckle.

The object of the invention is to provide an improved turnbuckle.

According to the invention a turnbuckle for use in securing one part to a second part comprises a body which is to be angularly free in a hole in said one part and having a head abutting one face of said one part; the body including a transverse bore in a portion of said body lying adjacent the opposite face of said one part; a spring clip located in said transverse bore, said clip projecting diametrically of said body so that respective ends of the clip may engage the respective parts when the turn buckle is in the appropriate position.

Preferably the two ends of the spring are at different axial locations relative to the body of the fastener so that one tail is normally in spring-urged frictional contact with said opposite face of said one part and in conjunction with the head on the one face of said part so as to retain the fastener in position relative to the part, whilst allowing rotation when required in order to move the other tail into and out of engagement with the other part. Where the other part lies between the one part and the second tail, the latter requires to be of different axial spacing due to the thickness of the second part but a further possibility includes a shaping of the spring so as to cause an additional deflection during the engagement and thus increase the spring force acting on the parts to hold them together.

One embodiment of the invention is now more particularly described with reference to the accompanying drawing wherein:
Figure 1 shows a cross sectional elevation of a trunking with a lid held in position by pairs of turnbuckle fasteners according to the invention;
Figure 2 is a sectional elevation on an enlarged scale showing one component of the fastener per se;
Figure 3 is an end elevation of the same component;
Figure 4 is an underneath plan view;
Figure 5 is a sectional elevation of the spring clip forming a part of the fastener per se;
Figure 6 is an underneath plan view of the same;
Figure 7 is a perspective view showing the assembled fastener.

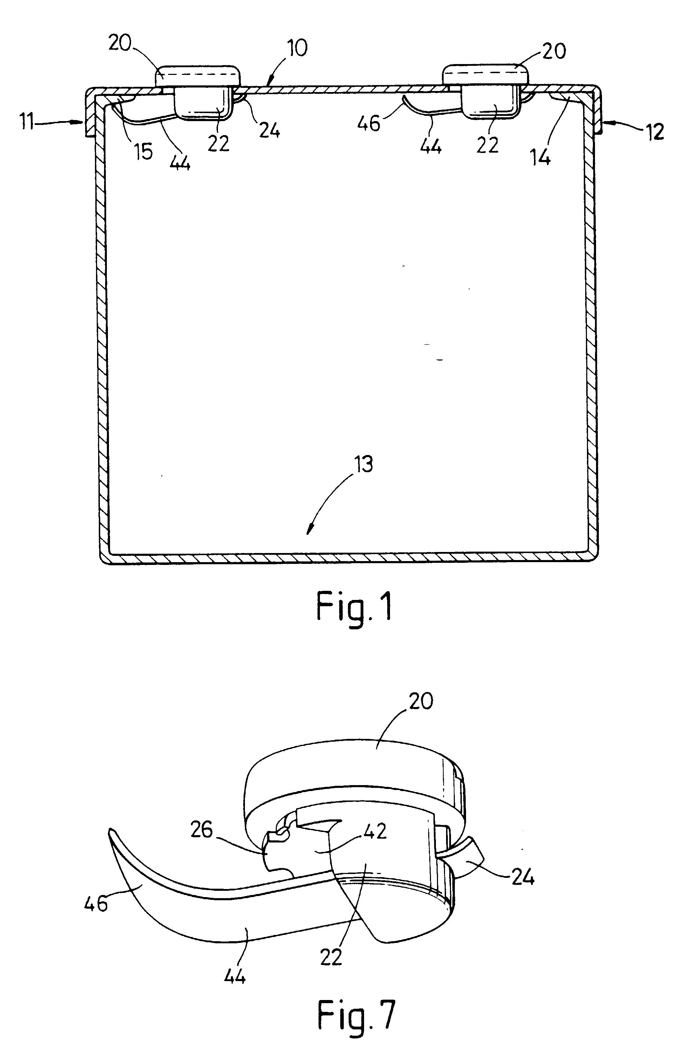

Turning now to the drawings, Figure 1 shows electrical trunking including a first part or lid 10 which has narrow side flanges 11, 12. The body of the trunking 12 is (in this particular embodiment) a substantially square channel with in-turned end edges 14, 15. The lid is secured to the body by a series of the fasteners of the invention providing two rows each being used to engage with one of the in-turned edges 14 or 15.

Turning next to Figure 7, the fastener comprises a head 20 which sits on the top face of the lid 10 and a shank 22 which is effectively journalled in a bore in the lid. To retain the fastener in position axially, while leaving it free for turning, the spring clip has parts 24, 26 which engage the underside of the lid at generally diametrically opposed positions. The clip also has the much longer radial tail 28 which, by rotation of the head 20 from the position shown at the right hand side of Figure 1 to the position shown at the left hand side of Figure 1, is turned from being directed towards the other fastener, to a position where it underlies the adjacent in-turned edge 14 or 15 and hence secures the parts together.

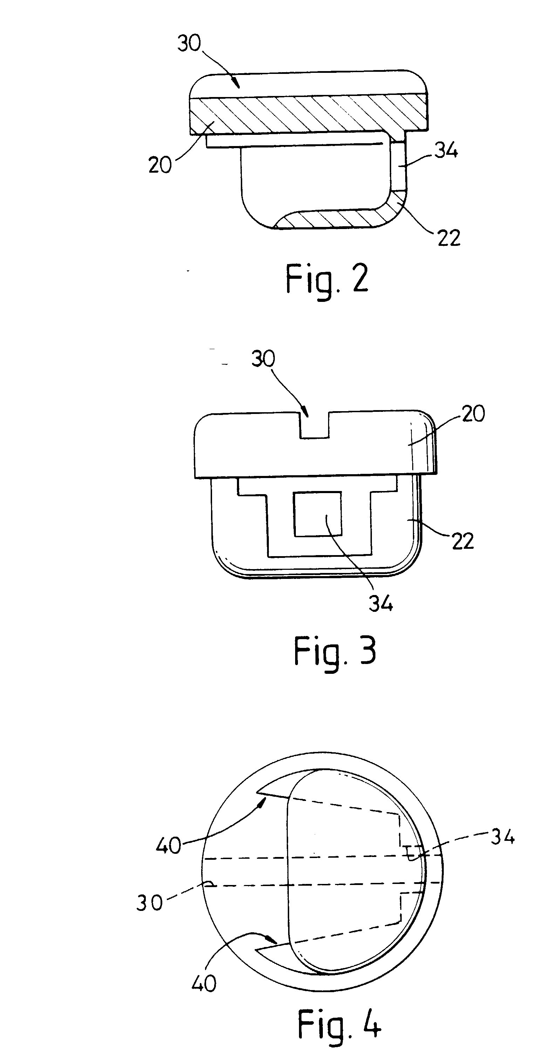

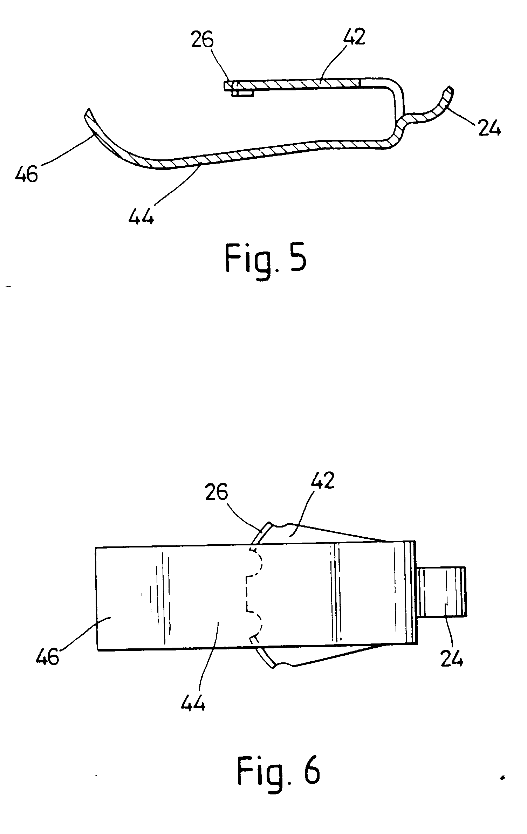

In more detail, the head 20 has a slot 30 for a screwdriver blade. The shank 22 has a transverse bore which opens through a restricted aperture 34, Figure 2, for the purpose of ensuring that when the spring (Figure 5) is inserted into the bore from the left hand side as seen in the drawing, it seats in the bore although the tail 24 is allowed to project through the aperture 34.

The sides of the aperture diverge as seen in Figure 4 with the reference numeral 40 and the spring as seen in Figures 5 and 6 is generally U-shaped, with one limb 42 which terminates in the end edge 26 being of complementary shape to the divergent part of the transverse bore and in practice this may enable the spring clip to become lightly wedged in that bore, which is convenient in assembly.

The longer limb of the spring 44, has an upwardly arcuate end portion 46 for contacting the underside of the in-turned edge 14 or 15 when the fastener is turned in the engaged position. Hence, the spring makes contact at opposite ends with the body and the lid and consequently provides electrical earth continuity therebetween.

## Claims

1. A turnbuckle for use in securing one part to a second part comprising a body which is to be angularly free in a hole in said one part and having a head abutting one face of said one part; the body including a transverse bore in a portion of said body lying adjacent the opposite face of said one part; a spring clip located in said transverse bore, said clip projecting diametrically of said body so that respective ends of the clip may engage the respective parts when the turnbuckle is in the appropriate position.

2. A turnbuckle as claimed in Claim 1 wherein a longer tail of said clip is for engagement with said second part, and a shorter tail of said clip which is diametrically related to the longer tail is to engage the opposite face of said first part.

3. A turnbuckle as claimed in Claim 2 wherein said clip is of U shape with unequal length limbs; the longer limb forms said longer tail, and the shorter tail is provided at the bridge of the U.

4. A turnbuckle as claimed in Claim 3 wherein the shorter limb also projects from the body at the same radial position as the said longer tail and is also to engage the opposite face of the first part.

5. A turnbuckle as claimed in Claim 1 wherein the transverse bore narrows within the body thereby to enable the spring to be wedged in the bore.

6. A turnbuckle as claimed in Claim 1 wherein the transverse bore opens through a restricted aperture at one end.
